# FASCICULE DE BREVET EUROPEEN

(11) **EP 3 001 446 B1**
(45) Date de publication et mention de la délivrance du brevet: **01.02.2017**
(21) Numéro de dépôt: 15184352.1
(22) Date de dépôt: 08.09.2015
(51) Int. Cl.: H01L 21/20, H01L 21/22, H01L 21/265, H01L 21/324

(54) **PROCÉDÉ DE FABRICATION D'UNE COUCHE SEMI-CONDUCTRICE À BASE DE GAN AMÉLIORÉ**
VERBESSERTES VERFAHREN ZUR HERSTELLUNG EINER HALBLEITERSCHICHT AUF GAN-BASIS
METHOD FOR MANUFACTURING AN IMPROVED GAN SEMICONDUCTOR LAYER

(30) Priorité: 26.09.2014 FR 1459132
(43) Date de publication de la demande: 30.03.2016
(73) Titulaire: Commissariat à l'Energie Atomique et aux Energies Alternatives, 75015 Paris (FR)
(72) Inventeur: Agraffeil, Claire, 38000 Grenoble (FR)
(74) Mandataire: Talbot, Alexandre

(56) Documents cités:
- US-A1- 2010 171 126
- ALURI GEETHA ET AL: "Microwave annealing of Mg-implanted and in situ Be-doped GaN", JOURNAL OF APPLIED PHYSICS, AMERICAN INSTITUTE OF PHYSICS, US, vol. 108, no. 8, 19 octobre 2010 (2010-10-19), pages 83103-83103, XP012143222, ISSN: 0021-8979, DOI: 10.1063/1.3493266
- HWANG J-D ET AL: "ENHANCING P-TYPE CONDUCTIVITY IN MG-DOPED GAN USING OXYGEN AND NITROGEN PLASMA ACTIVATION", JAPANESE JOURNAL OF APPLIED PHYSICS, JAPAN SOCIETY OF APPLIED PHYSICS, JP, vol. 44, no. 4A, 1 avril 2005 (2005-04-01) , pages 1726-1729, XP001245796, ISSN: 0021-4922, DOI: 10.1143/JJAP.44.1726
- KIM SANG-WOO ET AL: "Reactivation of Mg acceptor in Mg-doped GaN by nitrogen plasma treatment", APPLIED PHYSICS LETTERS, AMERICAN INSTITUTE OF PHYSICS, US, vol. 76, no. 21, 22 mai 2000 (2000-05-22), pages 3079-3081, XP012025381, ISSN: 0003-6951, DOI: 10.1063/1.126585
- AKIRA SHINTANI: "Etching of GaN Using Phosphoric Acid", JOURNAL OF THE ELECTROCHEMICAL SOCIETY, vol. 123, no. 5, 1 janvier 1976 (1976-01-01), page 706, XP055192093, ISSN: 0013-4651, DOI: 10.1149/1.2132914
- DUSHYANT GUPTA: "Plasma Immersion Ion Implantation (PIII) Process -Physics and Technology", INTERNATIONAL JOURNAL OF ADVANCEMENTS IN TECHNOLOGY, vol. 2, no. 4, 1 octobre 2011 (2011-10-01) , pages 471-490, XP055192384, ISSN: 0976-4860

## Description

### Domaine technique de l'invention

L'invention est relative à la réalisation d'une couche semi-conductrice à base de GaN dopée n ou p.

### État de la technique

L'implantation ionique est couramment utilisée pour doper des matériaux semi-conducteurs, et la nature des ions implantés est choisie en fonction du type de dopage que l'on souhaite obtenir.

Les ions Si⁺ sont souvent employés pour réaliser un dopage n (excès d'électrons) dans des semi-conducteurs à base de GaN, tandis que les ions Mg⁺ sont par exemple utilisés pour réaliser un dopage p (excès de trous). Un dopage efficace de type p à l'aide d'ions Mg⁺ est difficile à obtenir, aussi, il est préférable de réaliser une co-implantation Mg/P, Mg/N ou Be/O.

Après implantation, le semi-conducteur subit ensuite un traitement thermique afin d'activer plus ou moins efficacement les impuretés dopantes.

Cependant, le traitement thermique peut altérer la surface du matériau semi-conducteur si celui-ci est sensible aux effets de la température. Par exemple, le GaN est un semi-conducteur dont la surface peut être dégradée lorsque la température du recuit est supérieure à 850°C. Des fissures ou des trous peuvent apparaître à la surface du matériau semi-conducteur, en particulier lorsqu'un traitement thermique est réalisé à une température supérieure à 1000°C pendant une durée supérieure à plusieurs minutes.

Le traitement thermique engendre également une diffusion des dopants hors de la matrice semi-conductrice, mais aussi une contamination du semi-conducteur par des atomes tels que H, O, et Si (lorsque le semi-conducteur est déposé sur un substrat de silicium ou de manière plus générale en contact avec du silicium). Ces atomes diffusent dans la matrice semi-conductrice et engendrent une auto-compensation du dopage n ou p, ce qui limite le taux d'activation des ions dopants dans le semi-conducteur.

Pour empêcher la détérioration des semi-conducteurs et augmenter le taux d'activation des ions dopants après implantation, une couche de protection (« cap-layer » en anglais) peut être déposée au dessus du semi-conducteur. Le doit être réalisé avant le traitement thermique. La couche de protection permet de recuire le semi-conducteur à une température plus élevée que celle qu'il pourrait supporter à nu, et d'obtenir ainsi un semi-conducteur dopé ayant moins de défauts structurels et un meilleur taux d'activation.

Les matériaux semi-conducteurs à base de GaN apparaissent donc comme des matériaux particulièrement fragiles et malgré les précautions prises, les propriétés électriques du matériau semi-conducteur sont insuffisantes pour une utilisation industrielle notamment si le semi-conducteur est dopé p.

ALURI GEETHA ET AL: "Microwave annealing of Mg-implanted and in situ Be-doped GaN", JOURNAL OF APPLIED PHYSICS, AMERICAN INSTITUTE OF PHYSICS, US, vol. 108, no. 8, 19 octobre 2010, pages 83103-83103, XP012143222 divulgue un procédé de recuit d'un semi-conducteur à base de GaN dopé p. Le procédé comporte une étape de dépôt d'un film semi-conducteur sur un substrat, un étape d'implantation de dopants de type p, une étape de dépôt d'une couche de protection sur le film semi-conducteur, et une étape de recuit d'activation à haute température pendant un temps court et sous atmosphère contrôlée.

HWANG J-D ET AL: "ENHANCING P-TYPE CONDUCTIVITY IN MG-DOPED GAN USING OXYGEN AND NITROGEN PLASMA ACTIVATION",JAPANESE JOURNAL OF APPLIED PHYSICS, JAPAN SOCIETY OF APPLIED PHYSICS, JP, vol. 44, no. 4A, 1 avril 2005 (2005-04-01), pages 1726-1729, XP001245796,ISSN: 0021-4922, DOI: 10.1143/JJAP.44.1726 divulgue un procédé d'activation de dopants de type p dans un semi-conducteur à base de GaN. Une couche de GaN dopé p est déposée sur une couche de GaN non dopé, puis l'ensemble est recuit sous plasma.

KIM SANG-WOO ET AL: "Réactivation of Mg acceptor in Mg-doped GaN by nitrogen plasma treatment",APPLIED PHYSICS LETTERS, AMERICAN INSTITUTE OF PHYSICS, US, vol. 76, no. 21, 22 mai 2000 (2000-05-22), pages 3079-3081, XP012025381,ISSN: 0003-6951, DOI: 10.1063/1.126585 concerne également un procédé d'activation de dopants de type p dans une couche semi-conductrice de GaN par application d'un traitement par plasma d'azote.

### Objet de l'invention

Un objet de l'invention consiste à mettre en oeuvre un procédé de réalisation du matériau semi-conducteur destiné à améliorer ses performances électriques.

A cet effet, le procédé de fabrication d'un substrat comportant une couche en matériau semi-conducteur à base de GaN dopé et activé, le procédé comportant les étapes successives suivantes :
- prévoir ledit substrat dopé et activé,
- éliminer une partie de la couche en matériau semi-conducteur.

L'étape d'élimination est suivie d'un premier traitement thermique réalisé sous une atmosphère contenant de l'azote et dépourvue d'hydrogène.

Le première traîtement thermique est suivie d'une étape d'implantation de deuxièmes impuretés dopantes. Cette étape peut être réalisée par implantation ionique ou par immersion dans un plasma d'azote. La dose implantée est inférieure aux 2/3 de la dose implantée initialement dans la couche en matériau semi-conducteur. Le procédé peut également comprendre un deuxième traitement thermique réalisé sous une atmosphère contenant de l'azote et dépourvue d'hydrogène.

Le procédé peut également comprendre une étape de dépôt d'une couche additionnelle en matériau semi-conducteur à base de GaN, par croissance épitaxiale sur la couche en matériau semi-conducteur.

Le dépôt de la couche additionnelle en matériau semi-conducteur à base de GaN peut enfin être suivi d'un traitement thermique additionnel réalisé sous une atmosphère contenant de l'azote.

### Description sommaire des dessins

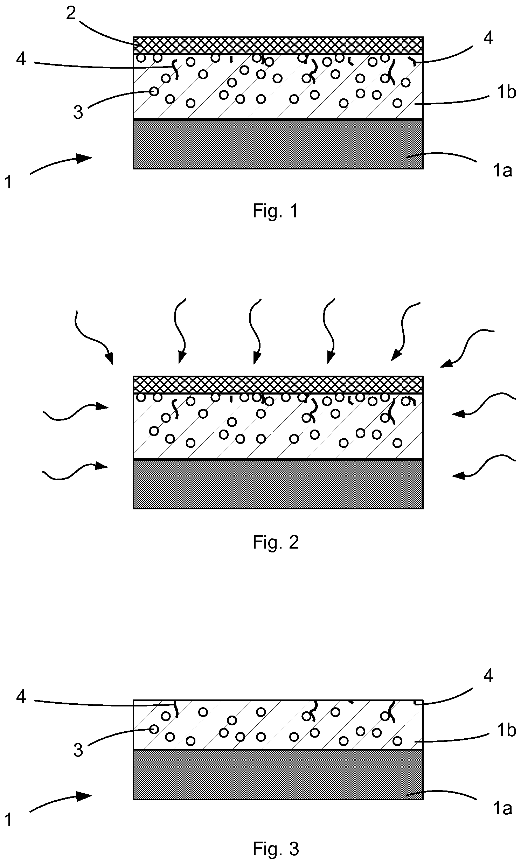

D'autres avantages et caractéristiques ressortiront plus clairement de la description qui va suivre de modes particuliers de réalisation de l'invention donnés à titre d'exemples non limitatifs et représentés aux dessins annexés, dans lesquels les figures 1 à 8 illustrent de façon schématique un mode de mise en oeuvre du procédé post-activation de dopants implantés dans une couche semi-conductrice à base de GaN.

### Description détaillée

Le procédé de réalisation est mis en oeuvre sur une couche en matériau semi-conducteur 1 b à base de GaN. Dans l'exemple illustré, le procédé est mis en oeuvre sur un substrat 1 qui comporte avantageusement un support 1 a par exemple en silicium, en sapphire, en Al2O3, ou en SiC, et une couche en matériau semi-conducteur 1 b GaN. La couche en matériau semi-conducteur 1 b à base de GaN est dopée avec des atomes dopants électriquement et ces derniers ont été activés, par exemple au moyen d'un recuit à haute température.

Le substrat 1 est avantageusement dopé par implantation de premières impuretés dopantes 3 de type Mg ou par une co-implantation d'ions Mg⁺ et P⁺. La dose de premières impuretés dopantes 3 est préférentiellement comprise entre 1.10¹⁴ et 1.10¹⁶ atomes/cm².

Le substrat 1 peut avoir été recouvert par une couche de protection 2 destinée à protéger la couche en matériau semi-conducteur 1 b lors du traitement thermique d'activation des premières impuretés dopantes 3. La couche de protection 2 forme alors une barrière configurée pour empêcher l'évaporation des molécules d'azote de la couche en matériau semi-conducteur 1 b lors du traitement thermique (cf. figure 1).

Lorsque le substrat 1 est un bloc de GaN massif, il est possible de recouvrir la face arrière d'une couche de protection 2 avantageusement identique à celle déposée sur le substrat 1 en face avant. La face avant du substrat 1 est définie ici comme la face impactée par le faisceau d'impuretés dopantes, et la face arrière comme la face opposée à la face avant.

Selon les modes de réalisation, la couche de protection 2 peut être formée avant ou après l'étape d'implantation des premières impuretés dopantes.

La couche de protection 2 peut avantageusement être à base de silicium lorsque le dopage recherché est de type n. Par à base de silicium, on entend que la couche de protection comporte au moins 30% atomique de silicium. Le matériau peut alors être du SiO₂ ou du Si₃N₄. Une couche de protection à base de silicium est particulièrement avantageuse si un dopage de type n est recherché. Lors d'un traitement thermique, des atomes de type Si peuvent diffuser en direction de la couche en matériau semi-conducteur 1 b pour renforcer le dopage de type n.

Le matériau de la couche de protection 2 peut également être dépourvu d'atomes de silicium. Avantageusement, la couche de protection 2 est en AIN. La couche de protection 2 permet d'empêcher la contamination de la couche semi-conductrice 1 b par des atomes de silicium ou d'oxygène. La couche de protection permet par exemple de conserver un dopage de type p de la couche 1 b.

Si le dopage est réalisé au moyen d'une implantation ionique, l'implantation ionique a créé des défauts structuraux 4 dans la matrice semi-conductrice. Un traitement thermique d'activation préférentiellement mis en oeuvre à une température supérieure à 1000°C, est réalisé après l'implantation (cf. figure 2). Ce traitement thermique permet d'activer les premières impuretés dopantes 3 et de réparer en partie les défauts structuraux 4. La qualité électrique de la couche en matériau semi-conducteur 1 b peut être améliorée car il y a une plus grande proportion de dopants électriquement actifs et au moins une partie des défauts structuraux est guérie.

Cependant, la couche en matériau semi-conducteur 1 b peut également avoir été dégradée par les différentes étapes technologiques subies jusqu'à présent et notamment des étapes d'implantation et de traitement thermique haute température.

L'utilisation de la couche de protection 2 comme barrière de diffusion entraine une accumulation des espèces dopantes à la surface de la couche 1 b au cours du traitement thermique. Cette accumulation d'espèces dopantes crée une composition chimique inhomogène de la surface de la couche en matériau semi-conducteur 1 b, en particulier lorsque la couche de protection 2 est réalisée en AIN ou en SiO₂. Il a été découvert que le traitement thermique d'activation provoque également une augmentation de la rugosité à l'interface entre le substrat 1 et la couche de protection 2.

Pour améliorer les performances électriques de la couche 1 b, il est particulièrement avantageux d'améliorer la qualité cristallographique de la couche en matériau semi-conducteur 1 b et plus particulièrement de la surface de la couche en matériau semi-conducteur 1 b. Pour cela, plusieurs étapes technologiques spécifiques peuvent être réalisées.

La partie supérieure de la couche 1 b étant la zone la plus abimée et/ou la plus contaminée, il faut éliminer non seulement la couche de protection 2 mais aussi une partie de la couche 1 b (cf. figure 3). La valeur de l'épaisseur retirée de la couche 1 b dépend du procédé subi préalablement. Cependant, il apparaît avantageux de retirer une portion de la couche 1 b d'épaisseur comprise entre 1 et 40nm, préférentiellement 1 à 20 nm, pour s'assurer de l'élimination d'une très grande proportion des défauts et/ou contaminants, tout en conservant la partie électriquement activée et dopée.

Le retrait de la couche de protection 2 et de la partie supérieure de la couche en matériau semi-conducteur 1 b peut par exemple être effectué par polissage mécano-chimique (« Chemical mechanical polishing » ou CMP en anglais).

Le polissage mécano-chimique consiste à polir la surface d'une pièce en exerçant une pression d'appui sur une pièce mise en rotation. Le polissage est réalisé de préférence en présence d'un liquide de polissage (slurry en anglais) pouvant contenir des particules abrasives et des particules destinée à réaliser une attaque chimique.

Pour retirer la couche de protection 2 et la partie supérieure de la couche en matériau semi-conducteur 1 b, le substrat 1 est maintenu fixe sur un plateau qui est mis en mouvement. Une pression comprise avantageusement entre 0,1 et 0,5 kg/cm est appliquée sur le substrat 1 de façon à le maintenir en contact avec le plateau.

En ce qui concerne le liquide de polissage, celui-ci peut comprendre 1 à 5% de billes d'Al₂O₃, ou 0,1 à 30% de billes de silice. L'Al₂O₃ et la silice jouent le rôle d'abrasif et concourent à l'arrachement de la couche de protection 2 lorsque le plateau est mis en rotation par rapport au substrat 1.

Pour réaliser une attaque chimique de la couche de protection 2, le pH du liquide de polissage peut être compris entre 2 et 11, et préférentiellement être égal à 10. Le liquide de polissage peut par exemple être une solution à base d'ammoniaque.

Lorsque la couche de protection 2 et une épaisseur suffisante de la couche en matériau semi-conducteur 1 b sont éliminées, le substrat 1 est rincé afin d'enlever les particules abrasives éventuellement présentes sur sa surface. La solution de rinçage peut être une solution d'ammoniaque.

En variante, la couche de protection 2 peut être éliminée par polissage mécano-chimique au moyen d'un premier jeu de conditions opératoires et la couche 1 b peut être partiellement éliminée par polissage mécano-chimique au moyen d'un deuxième jeu de conditions opératoires différent du premier jeu.

De manière alternative, la couche de protection 2 et la partie supérieure de la couche en matériau semi-conducteur 1 b peuvent être retirées par gravure chimique ou par gravure physique. Il est possible de réaliser une gravure par plasma et/ou une gravure par voie liquide.

Il peut également être envisagé de retirer la couche de protection 2 par polissage mécano-chimique et de retirer la partie supérieure de la couche en matériau semi-conducteur 1 b par une autre technique, ou inversement.

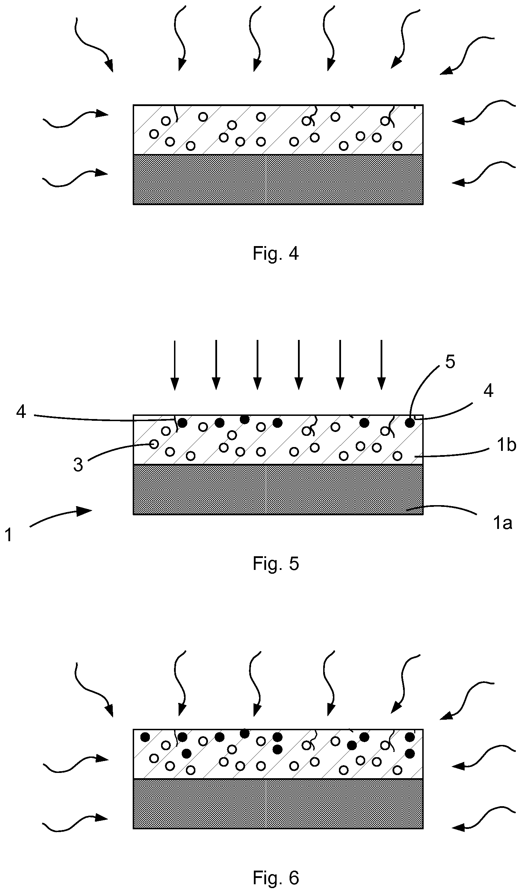

Le substrat 1 désormais à nu est soumis à un premier traitement thermique destiné à la fois à restructurer la surface endommagée de la couche en matériau semi-conducteur 1 b et à éliminer l'hydrogène présents dans la matrice semi-conductrice (cf. figure 4). En effet, il n'existe plus de couche de protection empêchant le dégazage du gaz H₂.

Si des ions Mg+ ont été introduits dans la couche 1 b, par exemple par implantation, le premier traitement thermique peut également être configuré pour causer la dissociation des complexes Mg-H créés lors du traitement thermique d'activation des premières impuretés dopantes 3.

Le premier traitement thermique de la surface peut être réalisé par une méthode dite « classique » (« furnace annealing » en anglais) ou par recuit thermique rapide (« Rapid termal annealing » ou RTA, et « Rapid termal processing » ou RTP en anglais).

Par exemple, lorsque le premier traitement thermique est réalisé par des techniques classiques, il est réalisé sous une atmosphère dépourvue d'hydrogène pour augmenter le dégazage d'hydrogène. L'atmosphère de recuit contient de l'azote, et peut être un mélange d'azote et d'oxygène, et peut également contenir du Ar, He ou NF₃.

La température du premier traitement thermique peut avantageusement être comprise entre 600 et 850°C et être préférentiellement égale à 750°C. Sa durée peut être comprise entre 5 et 120 min, et préférentiellement être égale à 20 min. Le choix de la technique de traitement thermique utilisée et des paramètres associés peuvent avantageusement être fait en fonction du type d'impuretés dopantes 3, de la quantité de défauts structuraux 4 dans la couche en matériau semi-conducteur 1 b, et des dimensions de cette dernière.

Il apparaît qu'une partie des défauts présents généralement dans la couche semi-conductrice 1 b sont des lacunes. Pour les combler, on réalise une implantation de deuxièmes impuretés dopantes 5 (cf. figure 5). Celle-ci peut être réalisée par toute technique adaptée et par exemple par un canon à ions ou par immersion plasma (« Plasma Immersion Ion Implantation » ou PIII en anglais). Les deuxièmes impuretés dopantes 5 sont avantageusement des éléments électriquement actifs ou non électriquement actifs destinés à combler les lacunes, et sont des ions N⁺ ou P⁺ ou un mélange d'ions N⁺ et P⁺.

Dans le cadre d'une implantation ionique à l'aide d'un canon à ions, l'implantation peut avantageusement être réalisée à une température comprise entre 15 et 700°C et être préférentiellement égale à 500°C. Le fait de se placer dans cette gamme de température permet d'éviter d'entrer dans des plages de températures où la surface du GaN se dégrade et où l'on observe un dégagement d'azote, ces phénomènes étant d'autant plus probables que la couche en matériau semi-conducteur 1 b subit un bombardement ionique. Ainsi, cette gamme de température permet à la fois de faciliter l'insertion des deuxièmes impuretés dopantes 5 dans la matrice pendant l'implantation, et la réorganisation de la matrice sous forme d'un réseau cristallin.

L'énergie d'implantation des deuxièmes impuretés dopantes 5 est avantageusement inférieure à celle des premières impuretés dopantes 3, de sorte à implanter les dopants 5 principalement à la surface de la couche semi-conductrice 1 b, c'est-à-dire dans la zone qui est la plus endommagée. Par ailleurs, les inventeurs ont observé que la dose de deuxièmes impuretés dopantes 5 implantée doit être inférieure aux deux tiers de la dose des premières impuretés dopantes 3 implantée dans la couche en matériau semi-conducteur 1 b. De cette façon, les lacunes crées par la première implantation sont comblées par les deuxièmes impuretés dopantes, sans endommager à nouveau le matériau.

La dose de deuxièmes impuretés dopantes 5 implantée peut avantageusement être comprise entre 0,1.10¹⁵ et 1,5.10¹⁵ atomes/cm², et être préférentiellement égale à 0,5.10¹⁵ atomes/cm². L'énergie des dopants 5 peut par ailleurs être comprise entre 10 et 150 keV, et préférentiellement être égale à 50 keV.

La dose implantée et l'énergie d'implantation des deuxièmes impuretés dopantes 5 permettent d'introduire des ions N⁺ là où la matrice semi-conductrice 1 b est la plus endommagée et en quantité suffisante pour la restaurer. De manière contre-intuitive, la matrice semi-conductrice 1 b à base de GaN est restaurée par l'implantation à haute température d'une dose contrôlée et à faible énergie des impuretés dopantes 5. Les lacunes des procédés de dopage et d'activation réalisés précédemment sont ainsi comblées.

Contrairement aux procédés de dopage de l'art antérieur dans lesquels deux types de matériaux sont successivement implantés avant de réaliser un traitement thermique d'activation des dopants, l'étape d'implantation des deuxièmes impuretés dopantes 5 est ultérieure au premier traitement thermique d'activation des premières impuretés dopantes 3. Cela permet de limiter les pertes en dopants, notamment de type p, et donc d'améliorer la qualité du dopage. La même zone de la couche en matériau semi-conducteur 1 b est dopée puis recuite puis dopée de nouveau.

La reconstruction de la matrice semi-conductrice est par ailleurs plus simple à mettre en oeuvre par rapport à ceux de l'art antérieur, lorsque le semi-conducteur comporte à la fois des zones dopées p et d'autres zones dopées n. En effet, la deuxième implantation d'impuretés dopantes 5 peut être directement réalisée sur l'ensemble de la couche en matériau semi-conducteur 1 b sans avoir recours à un masque de gravure. Ce mode de réalisation est particulièrement avantageux lorsque les impuretés dopantes 5 est non électriquement active ou est éventuellement une impureté dopante de type p.

En alternative, l'implantation des deuxièmes impuretés dopantes 5 peut être réalisée par immersion dans un plasma d'ions N⁺ à une température comprise entre 20 et 500°C, et préférentiellement égale à 500°C. La dose implantée peut avantageusement être comprise entre 0,1.10¹⁵ et 1,5.10¹⁵ atomes/cm², et être préférentiellement égale à 0,5.10¹⁵ atomes/cm². L'énergie d'implantation des deuxièmes impuretés dopantes 5 peut être comprise entre 5 et 40 keV, et être préférentiellement égale à 30 keV. L'implantation par immersion plasma est donc préférée lorsque les défauts 4 sont principalement en surface du substrat 1, puisque les énergies d'implantation sont plus faibles.

L'étape d'implantation crée des défauts structurels dans la couche en matériau semi-conducteur 1 b, et cette dernière peut donc avantageusement faire l'objet d'un deuxième traitement thermique (cf. figure 6). Ce traitement thermique permet également d'éliminer des atomes H de la matrice semi-conductrice par dégazage de H₂. La combinaison d'une étape d'implantation suivie par un traitement thermique permet d'améliorer la qualité de la matrice semi-conductrice 1 b par rapport à l'application d'un simple traitement thermique.

Le deuxième traitement thermique peut être un traitement de type RTA, réalisé sous atmosphère contenant de azote et avantageusement dépourvue d'hydrogène et d'oxygène afin d'éviter toute contamination de la couche en matériau semi-conducteur 1 b par des atomes H ou O, mais aussi favoriser le dégazage d'hydrogène du matériau. L'atmosphère dans laquelle le traitement thermique est réalisé peut éventuellement contenir du Ar, He ou NF₃.

Le deuxième traitement thermique peut être un recuit unique, ou comprendre une série de 5 à 40 cycles de recuit, chaque cycle ayant une durée de 2 à 20 secondes. Dans un mode de mise en oeuvre particulier, le deuxième traitement thermique peut comprendre 10 cycles de 5 secondes chacun.

En alternative, le deuxième traitement thermique peut être un recuit standard réalisé dans une atmosphère dépourvue d'oxygène, pendant une durée comprise entre 15 et 25min.

Quelle que soit la méthode utilisée pour réaliser le deuxième traitement thermique, la température à laquelle ce recuit est effectué peut être comprise entre 600 et 850°C, et préférentiellement être égale à 750°C. La température élevée de ce traitement thermique permet de guérir la couche semi-conductrice 1 b de ses défauts par réarrangements atomiques, sans pour autant entrainer une évaporation d'azote.

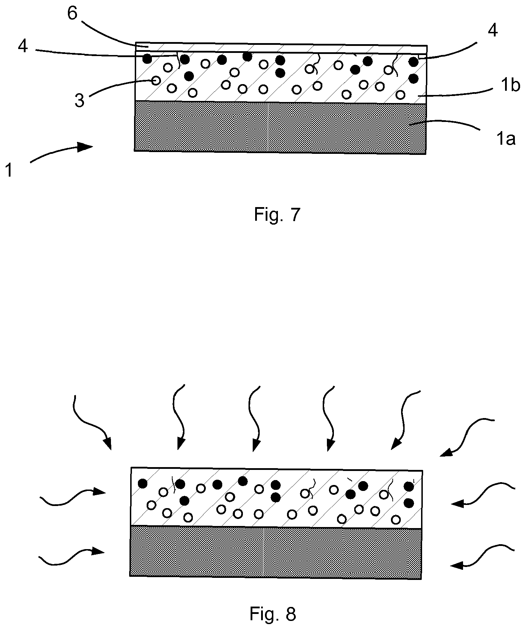

A l'issue du deuxième traitement thermique, le procédé peut comprendre une étape de reconstruction de la surface endommagée de la couche en matériau semi-conducteur 1 b (cf. figure 7). Cette étape de reconstruction peut comprendre un dépôt de matériau semi-conducteur 6 à base de GaN réalisé par exemple par épitaxie en phase vapeur aux organométalliques (« Metalorganic Chemical Vapor Déposition » ou MOCVD en anglais) à une température comprise entre 1000 et 1100°C.

La couche 6 peut par exemple être une couche d'AlGaN (i.e. AI(0-50%)Ga(0-50%)N), ou de GaN (i.e. Al(0%)Ga(100%)N). La couche 6 peut être dopée par des atomes de Mg dans le cas d'un dopage p.

La couche en matériau semi-conducteur 6 déposée peut avantageusement correspondre à une couche d'épaisseur comprise entre 1 et 40 nm. L'épaisseur de la couche 6 dépend de l'utilisation prévue pour le substrat 1, elle n'est pas nécessairement identique à l'épaisseur éliminée lors de l'étape d'élimination de la partie supérieure de la couche semi-conductrice 1 b représentée à la figure 3. Cette épaisseur peut être comprise entre 1 et 40 nm, préférentiellement comprise entre 1 et 20 nm, et idéalement égale à 5 nm.

Cette épaisseur permet de garantir la qualité électrique du semi-conducteur. En effet, le dépôt de la couche étant réalisé à une température comprise entre 1000 et 1100°C, les impuretés dopantes électriques 3 et 5 peuvent migrer dans la couche 6 et assurer une conductivité électrique similaire à celle de la couche 1 b.

A la suite de l'étape d'épitaxie, il est avantageux de réaliser un troisième traitement thermique permettant l'élimination d'une partie des atomes d'hydrogène présents dans la couche 6 (cf. figure 8).

Le troisième traitement thermique peut avantageusement être réalisé sous atmosphère avantageusement dépourvue d'hydrogène et d'oxygène, et contenant de l'azote afin d'éviter la contamination du matériau à base de GaN par des atomes H, O ou C. La température du troisième traitement thermique peut avantageusement être comprise entre 750 et 900°C, et préférentiellement être égale à 800°C. Sa durée peut être comprise entre 15 et 120 min, et préférentiellement être inférieure ou égale à 20min lorsque la température est de 900°C, ou égale à 20 min sinon.

De manière avantageuse, le troisième traitement thermique est réalisé à la suite de l'étape d'épitaxie sans que la couche 6 ne soit soumise à une atmosphère oxydante. Il peut être avantageusement réalisé dans le suscepteur ayant servi pour l'épitaxie de la couche en matériau semi-conducteur 6.

On obtient ainsi un semi-conducteur ayant un taux d'activation de dopants élevé et dont la qualité cristalline est améliorée, de sorte à avoir un matériau ayant non seulement une bonne qualité électrique, mais aussi un état de surface amélioré et qui soit moins résistif que dans l'art antérieur.

## Revendications

1. Procédé de fabrication d'un substrat (1) comportant une couche en matériau semi-conducteur (1b) à base de GaN dopé et activé au moyen de premières impuretés dopantes (3), le procédé comportant les étapes successives suivantes :
• prévoir ledit substrat (1) comportant une couche en matériau semi-conducteur (1b) à base de GaN,
• doper ladite couche (1b) au moyen d'une implantation ionique avec des premières impuretés dopantes (3),
• activer les premières impuretés dopantes (3),
• éliminer une partie de la couche en matériau semi-conducteur (1 b),
• réaliser un premier traitement thermique sous une atmosphère contenant de l'azote et dépourvue d'hydrogène,
• implanter des deuxièmes impuretés dopantes (5) choisies parmi N, P, ou un mélange N/P, la dose de deuxièmes impuretés dopantes (5) implantée étant inférieure aux 2/3 de la dose utilisée pour l'implantation des premières impuretés dopantes (3) dans la couche en matériau semi-conducteur (1b),

2. Procédé de fabrication selon la revendication 1, dans lequel le premier traitement thermique est réalisé à une température comprise entre 600 et 1000°C.

3. Procédé de fabrication selon l'une quelconque des revendications 1 ou 2, dans lequel le premier traitement thermique est effectué pendant une durée comprise entre 5 et 120 min.

4. Procédé de fabrication selon l'une quelconque des revendications 1 à 3, dans lequel l'implantation des deuxièmes impuretés dopantes (5) est réalisée à l'aide d'un canon à ions, à une température comprise entre 20 et 700°C, et à une énergie comprise entre 10 et 150 keV.

5. Procédé de fabrication selon l'une quelconque des revendications 1 à 4, dans lequel l'implantation des deuxièmes impuretés dopantes (5) est réalisée à l'aide d'un canon à ions, à une température égale à 500°C, et à une énergie égale à 50 keV.

6. Procédé de fabrication selon l'une quelconque des revendications 1 à 3, dans lequel l'implantation des deuxièmes impuretés dopantes (5) est réalisée par immersion dans un plasma d'azote à une température comprise entre 20 et 700°C, et à une énergie comprise entre 5 et 40 keV.

7. Procédé de fabrication selon l'une quelconque des revendications 1 à 4 et 6, dans lequel l'implantation des deuxièmes impuretés dopantes (5) est réalisée par immersion dans un plasma d'azote à une température égale à 500°C, et à une énergie égale à 30 keV.

8. Procédé de fabrication selon l'une quelconque des revendications 1 à 7, dans lequel l'implantation des deuxième impuretés dopantes (5) est suivie d'un deuxième traitement thermique réalisé sous une atmosphère contenant de l'azote et dépourvue d'hydrogène et d'oxygène.

9. Procédé de fabrication selon la revendication 8, dans lequel le deuxième traitement thermique est réalisé à une température comprise entre 600 et 850°C.

10. Procédé de fabrication selon l'une quelconque des revendications 1 à 9, comportant une étape de dépôt d'une couche additionnelle en matériau semi-conducteur (6) à base de GaN par croissance épitaxiale sur la couche en matériau semi-conducteur (1 b).

11. Procédé de fabrication selon la revendication 10, dans lequel la couche additionnelle en matériau semi-conducteur (6) a une épaisseur comprise entre 1 à 40 nm.

12. Procédé de fabrication selon l'une quelconque des revendications 10 ou 11, dans lequel le dépôt de la couche additionnelle en matériau semi-conducteur (6) est suivi d'un troisième traitement thermique réalisé sous atmosphère contenant de l'azote et dépourvue d'hydrogène et d'oxygène.

13. Procédé de fabrication selon la revendication 12, dans lequel le troisième traitement thermique est réalisé à une température comprise entre 750 et 900°C.

14. Procédé de fabrication selon l'une quelconque des revendications 12 ou 13, dans lequel le troisième traitement thermique est réalisé pendant une durée comprise entre 15 et 120 min.

15. Procédé de fabrication selon l'une quelconque des revendications 1 à 14, dans lequel la partie de la couche en matériau semi-conducteur (1b) qui est éliminée a une épaisseur comprise entre 1 et 40 nm.

## Patentansprüche

1. Verfahren zur Herstellung eines Substrats (1), das eine Schicht aus Halbleitermaterial (1b) auf Basis von dotiertem und mittels erster Dotierungsstörstellen (3) aktiviertem GaN umfasst, wobei das Verfahren die folgenden aufeinanderfolgenden Schritte umfasst:
• Vorsehen des Substrats (1), das eine Schicht aus Halbleitermaterial (1b) auf Basis von GaN umfasst,
• Dotieren der Schicht (1b) mittels einer Ionenimplantation mit ersten Dotierungsstörstellen (3),
• Aktivieren der ersten Dotierungsstörstellen (3),
• Entfernen eines Teils der Schicht aus Halbleitermaterial (1b),
• Durchführen einer ersten Wärmebehandlung unter einer Atmosphäre, die Stickstoff enthält und frei von Wasserstoff ist,
• Implantieren von zweiten Dotierungsstörstellen (5), die aus N, P oder einer N/P-Mischung ausgewählt sind, wobei die implantierte Dosis von zweiten Dotierungsstörstellen (5) kleiner als 2/3 der Dosis ist, die für die Implantation der ersten Dotierungsstörstellen (3) in die Halbleitermaterialschicht (1b) verwendet wird.

2. Herstellungsverfahren nach Anspruch 1, bei dem die erste Wärmebehandlung bei einer Temperatur im Bereich zwischen 600 und 1000 °C durchgeführt wird.

3. Herstellungsverfahren nach einem der Ansprüche 1 oder 2, bei dem die erste Wärmebehandlung über eine Dauer zwischen 5 und 120 Min. durchgeführt wird.

4. Herstellungsverfahren nach einem der Ansprüche 1 bis 3, bei dem die Implantation der zweiten Dotierungsstörstellen (5) mit Hilfe einer Ionenkanone bei einer Temperatur im Bereich zwischen 20 und 700 °C und mit einer Energie im Bereich zwischen 10 und 150 keV durchgeführt wird.

5. Herstellungsverfahren nach einem der Ansprüche 1 bis 4, bei dem die Implantation der zweiten Dotierungsstörstellen (5) mit Hilfe einer Ionenkanone bei einer Temperatur von gleich 500 °C und mit einer Energie von gleich 50 keV durchgeführt wird.

6. Herstellungsverfahren nach einem der Ansprüche 1 bis 3, bei dem die Implantation der zweiten Dotierungsstörstellen (5) durch Eintauchen in ein Stickstoffplasma bei einer Temperatur im Bereich zwischen 20 und 700 °C und mit einer Energie im Bereich zwischen 5 und 40 keV durchgeführt wird.

7. Herstellungsverfahren nach einem der Ansprüche 1 bis 4 und 6, bei dem die Implantation der zweiten Dotierungsstörstellen (5) durch Eintauchen in ein Stickstoffplasma bei einer Temperatur von gleich 500 °C und mit einer Energie von gleich 30 keV durchgeführt wird.

8. Herstellungsverfahren nach einem der Ansprüche 1 bis 7, bei dem sich an die Implantation der zweiten Dotierungsstörstellen (5) eine zweite Wärmebehandlung anschließt, die unter einer Atmosphäre, welche Stickstoff enthält und frei von Wasserstoff und von Sauerstoff ist, durchgeführt wird.

9. Herstellungsverfahren nach Anspruch 8, bei dem die zweite Wärmebehandlung bei einer Temperatur im Bereich zwischen 600 und 850 °C durchgeführt wird.

10. Herstellungsverfahren nach einem der Ansprüche 1 bis 9, umfassend einen Schritt zur Abscheidung einer zusätzlichen Schicht aus Halbleitermaterial (6) auf GaN-Basis durch epitaxiales Aufwachsen auf der Halbleitermaterialschicht (1b).

11. Herstellungsverfahren nach Anspruch 10, bei dem die zusätzliche Schicht aus Halbleitermaterial (6) eine Dicke zwischen 1 und 40 nm aufweist.

12. Herstellungsverfahren nach einem der Ansprüche 10 oder 11, bei dem sich an das Abscheiden der zusätzlichen Schicht aus Halbleitermaterial (6) eine dritte Wärmebehandlung anschließt, die unter einer Atmosphäre, welche Stickstoff enthält und frei von Wasserstoff und von Sauerstoff ist, durchgeführt wird.

13. Herstellungsverfahren nach Anspruch 12, bei dem die dritte Wärmebehandlung bei einer Temperatur im Bereich zwischen 750 und 900 °C durchgeführt wird.

14. Herstellungsverfahren nach einem der Ansprüche 12 oder 13, bei dem die dritte Wärmebehandlung über eine Dauer von 15 bis 120 Min. durchgeführt wird.

15. Herstellungsverfahren nach einem der Ansprüche 1 bis 14, bei dem der Teil der Halbleitermaterialschicht (1b), welcher entfernt wird, eine Dicke zwischen 1 und 40 nm aufweist.

## Claims

1. A method for fabricating a substrate (1) comprising a layer made from doped and activated GaN-based semiconductor material (1 b) with first dopant impurities (3), the method comprising the following successive steps:
• providing said substrate (1) comprising a GaN-based semiconductor material layer (1 b),
• doping said layer (1 b) by means of an ion implantation with first dopant impurities (3),
• activating the first dopant impurities (3),
• eliminating a part of the semiconductor material layer (1 b),
• performing a first heat treatment step in an atmosphere containing nitrogen and devoid of hydrogen,
• implanting second dopant impurities (5) chosen among N, P, or a N/P mixture, the dose of second dopant impurities (5) being less than 2/3 of the dose used for implantation of the first dopant impurities (3) in the GaN-based semiconductor material layer (1 b).

2. The fabrication method according to claim 1, wherein the first heat treatment is performed at a temperature comprised between 600 and 1000°C.

3. The fabrication method according to either one of claims 1 or 2, wherein the first heat treatment is performed for a period comprised between 5 and 120 min.

4. The fabrication method according to any one of claims 1 to 3, wherein implantation of the second dopant impurities (5) is performed by means of an ion gun at a temperature comprised between 20 and 700°C, and at an energy comprised between 10 and 150 keV.

5. The fabrication method according to any one of claims 1 to 4, wherein implantation of the second dopant impurities (5) is performed by means of an ion gun at a temperature equal to 500°C, and at an energy equal to 50 keV.

6. The fabrication method according to any one of claims 1 to 3, wherein implantation of the second dopant impurities (5) is performed by immersion in a nitrogen plasma at a temperature comprised between 20 and 700°C, and at an energy comprised between 5 and 40 keV.

7. The fabrication method according to any one of claims 1 to 3 and 6, wherein implantation of the second dopant impurities (5) is performed by immersion in a nitrogen plasma at a temperature equal to 500°C, and at an energy equal to 30 keV.

8. The fabrication method according to any one of claims 1 to 7, wherein implantation of the second dopant impurities (5) is followed by a second heat treatment performed in an atmosphere containing nitrogen and devoid of hydrogen and oxygen.

9. The fabrication method according to claim 8, wherein the second heat treatment is performed at a temperature comprised between 600 and 850°C.

10. The fabrication method according to any one of claims 1 to 9, comprising a deposition step of an additional layer of GaN-based semiconductor material (6) by epitaxial growth on the semiconductor material layer (1 b).

11. The fabrication method according to claim 10, wherein the additional semiconductor material layer (6) has a thickness comprised between 1 and 40 nm.

12. The fabrication method according to either one of claims 10 or 11, wherein deposition of the additional semiconductor material layer (6) is followed by a third heat treatment performed in an atmosphere containing nitrogen and devoid of hydrogen and oxygen.

13. The fabrication method according to claim 12, wherein the third heat treatment is performed at a temperature comprised between 750 and 900°C, preferentially equal to 800°C.

14. The fabrication method according to either one of claims 12 or 13, wherein the third heat treatment is performed for a period comprised between 15 and 120 min.

15. The fabrication method according to any one of claims 1 to 14, wherein the part of the semiconductor material layer (1 b) which is eliminated has a thickness comprised between 1 and 40 nm.
